# EUROPÄISCHE PATENTSCHRIFT

(11) **EP 4 524 507 B1**
(45) Veröffentlichungstag und Bekanntmachung des Hinweises auf die Patenterteilung: **21.01.2026**
(21) Anmeldenummer: 24198415.2
(22) Anmeldetag: 04.09.2024
(51) Int. Cl.: G01B 7/00, G01R 33/00, G06F 13/00, G08C 21/00

(54) **VERFAHREN UND ANORDNUNG ZUM ERMITTELN EINER REIHENFOLGE ANEINANDERGEREIHTER KOMMUNIKATIONSFÄHIGER MODULE**
METHOD AND ARRANGEMENT FOR DETERMINING AN ORDER OF COMMUNICATION-CAPABLE MODULES ARRANGED NEXT TO EACH OTHER
PROCÉDÉ ET DISPOSITIF POUR DÉTERMINER UNE SÉQUENCE DE MODULES CAPABLES DE COMMUNICATION CONTIGUS

(30) Priorität: 14.09.2023 DE 102023124841
(43) Veröffentlichungstag der Anmeldung: 19.03.2025
(73) Patentinhaber: Weidmüller Interface GmbH & Co. KG, 32758 Detmold (DE)
(72) Erfinder: ROSE, Gorm, 33100 Paderborn (DE)
(74) Vertreter: Kleine, Hubertus

(56) Entgegenhaltungen:
- EP-A1- 2 031 625
- DE-B4- 102005 025 703
- US-A1- 2017 116 145
- US-B2- 7 773 569

## Beschreibung

Die Erfindung betrifft ein Verfahren zum Ermitteln einer Reihenfolge, in der mindestens drei aneinandergereihte kommunikationsfähige Module angeordnet sind. Die Erfindung betrifft weiterhin eine Anordnung aus mindestens drei aneinanderreihbaren kommunikationsfähigen Modulen, mit der ein derartiges Verfahren durchführbar ist.

In der Elektroinstallation und der Automatisierungstechnik werden häufig Anordnungen von aneinandergereihten kommunikationsfähigen Modulen eingesetzt. Ein Beispiel aus der Automatisierungstechnik sind sog. "Remote-I/O"-Systeme, also Systeme zur Ein- und Ausgabe von Signalen und/oder Daten, die entfernt von einer Steuereinrichtung z. B. in einem Schaltschrank angeordnet sind. Diese Systeme umfassen i. d. R. ein Kopfmodul, auch Kopfstation genannt, das eine Verbindung zum Steuerungssystem aufbaut, und mehrere I/O (Input/Output, also Eingabe und Ausgabe) - Module, die an das Kopfmodul angereiht werden. Zu dem Zweck weisen die Module jeweils eine Hutschienenaufnahme auf und meist zusätzlich Rastmittel zur mechanischen Verbindung zu einem benachbarten Modul.

Mit dem mechanischen Anreihen können auch elektrische Verbindungen zwischen den Modulen etabliert werden, die z.B. dem Aufbau eines Stromversorgungsbusses und/oder dem Aufbau eines Datenbusses zwischen den Modulen und Kopfstation dienen. Selbst wenn es für die Funktionalität des Bussystems nicht unbedingt notwendig ist, kann es für zusätzliche Dienste von Interesse sein, Informationen über eine Reihenfolge zu erhalten, in der die Module aneinandergereiht sind. Beispielsweise kann mit dieser Information eine Fehlersuche am I/O-System vereinfacht werden, da die physikalische Position eines fehlerhaften Moduls visualisiert werden kann, wenn die Reihenfolge bekannt ist.

Die gleiche Problematik kann sich auch bei aneinandergereihten Modulen ergeben, die keinen drahtgebundenen Datenbus beim Aneinanderreihen aufbauen, sondern die unabhängig voneinander drahtlos z.B. mit einem Verteiler, beispielsweise einem Switch oder Gateway, kommunizieren. Auch dabei ist unter Umständen eine Reihenfolge der Aneinanderreihung dieser unabhängig voneinander kommunizierenden Module von Interesse.

US 2017/116145 A1 beschreibt ein elektrisches Schnittstellenmodul mit drahtloser Schnittstelle zur Datenübertragung und eindeutiger Identifikation. Es bildet mit benachbarten Modulen einen bidirektionalen Datenbus, erkennt Fehlerzustände und ermöglicht die Darstellung der physischen Anordnung. Module können Daten und Energie austauschen, nützlich bei Fehlerzuständen.

Es ist eine Aufgabe der vorliegenden Erfindung, ein Verfahren zu beschreiben, mit dem eine Reihenfolge von aneinandergereihten kommunikationsfähigen Modulen innerhalb einer Anordnung ermittelt werden kann. Es ist eine weitere Aufgabe, eine zur Durchführung des Verfahrens geeignete Anordnung von aneinanderreihbaren kommunikationsfähigen Modulen zu beschreiben.

Diese Aufgabe wird gelöst durch ein Verfahren bzw. eine Anordnung mit den Merkmalen des jeweiligen unabhängigen Anspruchs. Vorteilhafte Ausgestaltungen und Weiterbildungen sind Gegenstand der abhängigen Ansprüche.

Ein erfindungsgemäßes Verfahren der eingangs genannten Art zeichnet sich durch die folgenden Schritte aus: Es wird ein magnetisches Signal von einem ersten der Module mit einer vorgegebenen Intensität gesendet. Die Intensität des Signals wird dann z.B. kontinuierlich oder schrittweise gesteigert, bis das Signal von einem unmittelbar an das sendende Modul angrenzenden Modul detektiert wird, von einem nicht unmittelbar angrenzenden Modul jedoch nicht detektiert wird. Nach dem Detektieren des Signals gibt das Modul, das das Signal detektiert hat, Daten zu seiner Identifizierung über einen Kommunikationskanal an eine Erfassungseinheit aus, die unter Nutzung der Identifikationsdaten eine Reihenfolge der Module erfasst.

Es wird also erfindungsgemäß unabhängig von dem Kommunikationskanal ein magnetisches Signal von dem ersten Modul ausgegeben, das in seiner Intensität gesteigert wird. Durch die Steigerung der Intensität steigt die Reichweite, innerhalb der das magnetische Signal bei einer gegebenen Detektionssensitivität von einem weiteren Modul detektierbar ist. Das Ansteigen der Intensität des Signals stellt sicher, dass das Signal zuerst von einem unmittelbar benachbarten Modul detektiert wird. Dieses Modul weist sich daraufhin als unmittelbarer Nachbar mithilfe seiner Identifikationsdaten aus, die über den Kommunikationskanal übermittelt werden.

Das Verfahren nutzt somit die ansteigende Reichweite des magnetischen Signals zur Detektion eines Moduls aus und bedient sich dann des Kommunikationskanals, um die Identifikationsdaten zu übermitteln. Weiter kann der Kommunikationskanal auch zur Koordination des Verfahrens unter den verschiedenen teilnehmenden Einheiten, d.h. den Modulen und der Erfassungseinheit genutzt werden.

Die Ermittlung der Reihenfolge ist unabhängig von dem Typ des Kommunikationskanals und kann sowohl bei drahtgebunden kommunizierenden, als auch bei drahtlos kommunizierenden Modulen eingesetzt werden. Auch kann die Kommunikation über ein Bussystem oder über ein Netzwerk stattfinden.

Eine erfindungsgemäße Anordnung umfasst mindestens drei Module, die jeweils eine Kommunikationseinheit aufweisen, sowie eine Spule zum Abgeben und/oder Empfangen eines magnetischen Signals. Die Anordnung umfasst weiter eine Erfassungseinheit und ist zur Durchführung des zuvor genannten Verfahrens eingerichtet.

Bevorzugt wird als erstes Modul ein insofern ausgezeichnetes Modul eingesetzt, das sich an einem äußeren Rand der Anordnung befindet. Eine mögliche Ambivalenz, die daher rührt, dass es zu jeder Seite einen nächsten Nachbarn geben könnte, wird so ausgeschaltet. Häufig weisen Anordnungen der beschriebenen Art an einem äußeren Rand ein Modul auf, das auch als Busmaster für einen unter den Modulen aufgebauten Datenbus fungiert. Eine solches Modul, das den Busmaster in der Anordnung darstellt, ist eine bevorzugte Wahl für das erste Modul des erfindungsgemäßen Verfahrens.

In einer vorteilhaften Weiterbildung des Verfahrens ist vorgesehen, dass nach dem Ausgeben der Identifikationsdaten des empfangenden Moduls die Intensität des Signals weiter gesteigert wird, bis das magnetische Signal von einem weiteren Modul detektiert wird. Auch dieses weitere Modul gibt seine Identifikationsdaten aus. Anhand der Identifikationsdaten kann z.B. eine Liste der angeordneten Module fortgeführt werden. Dieses Verfahren kann auf gleiche Weise wiederholt werden, bis alle Module der Anordnung erfasst sind.

In einer weiteren vorteilhaften Ausgestaltung des Verfahrens ist vorgesehen, nach einem Detektieren des Signals die Ausgabe des Signals von dem ersten Modul zu beenden und ein weiteres magnetisches Identifikationssignal von dem Modul auszugeben, das seine Identifikationsdaten ausgegeben hat. Auf diese Weise kann das Verfahren auch bei Anordnung auch mit einer großen Zahl von Modulen durchgeführt werden, wenn das magnetische Identifikationssignal ausgehend von einem ersten Modul am Rand der Anordnung sich nicht bis zum letzten Modul am gegenüberliegenden Rand der Anordnung erstreckt. Bevorzugt beteiligt sich das genannte erste Modul dann nicht weiter an dem Verfahren und reagiert insbesondere auch nicht mehr auf Magnetfelder, die im Rahmen dieses Identifikationszyklus noch gesendet werden.

Zur Ausgabe und/oder zum Empfangen des magnetischen Signals ist in einer Ausgestaltung eine Spule in jedem Modul angeordnet, wobei eine axiale Richtung der Spule in Anreihrichtung der Module ausgerichtet ist. Bevorzugt sind die Spulen so innerhalb der Module positioniert, dass alle Spulen beim Aneinanderreihen der Module auf einer gemeinsamen Achse angeordnet sind. Bevorzugt sind die Spulen auf einem Spulenkern angeordnet, der sich ebenfalls in Anreihrichtung der Module erstreckt. Besonders bevorzugt ist der Kern ein stabförmiger und zu beiden Seiten offener Kern, insbesondere ein Ferritkern.

Weiter bevorzugt wird das magnetische Identifizierungssignal erzeugt, indem ein elektrischer Puls mit variabler Länge auf die Spule aufgeschaltet wird. Insbesondere ist der Puls ein rechteckförmiger Spannungspuls. Durch die Induktivität der Spule steigt bei einem rechteckförmigen Spannungspuls, der auf die Spule gegeben wird, die magnetische Feldstärke monoton, in erster Näherung linear, mit der Zeit an, so dass das Signal mit einer magnetischen Feldstärkeamplitude erzeugt wird, die von der Länge des Spannungspulses abhängig ist. Damit kann die Reichweite des Magnetsignals auf einfache Weise durch Variation der Pulslänge verändert werden.

Die Erfindung wird nachfolgend anhand von Ausführungsbeispielen mithilfe von Figuren näher erläutert. Die Figuren zeigen:
- Figur 1: eine Anordnung mehrerer kommunikationsfähiger aneinandergereihter Module in einer räumlichen Darstellung;
- Figur 2: eine Seitenansicht der Anordnung gemäß Figur 1;
- Figur 3: eine teilgeschnittene räumliche Darstellung eines Kopfmoduls der Anordnung der Figuren 1 und 2;
- Figur 4: eine räumliche Darstellung eines weiteren Moduls der Anordnung der Figuren 1 und 2; und
- Figur 5: ein Flussdiagramm eines Ausführungsbeispiels eines Verfahrens zur Bestimmung einer Reihenfolge aneinandergereihter Module.

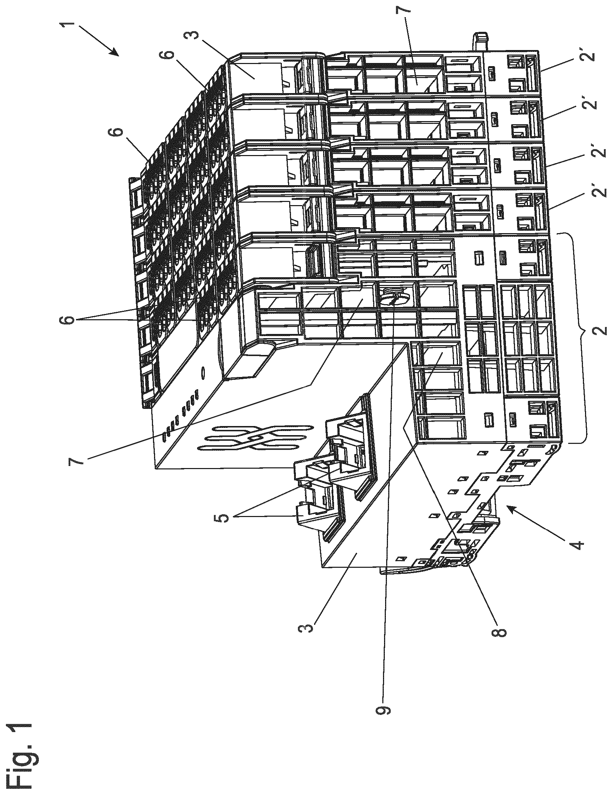

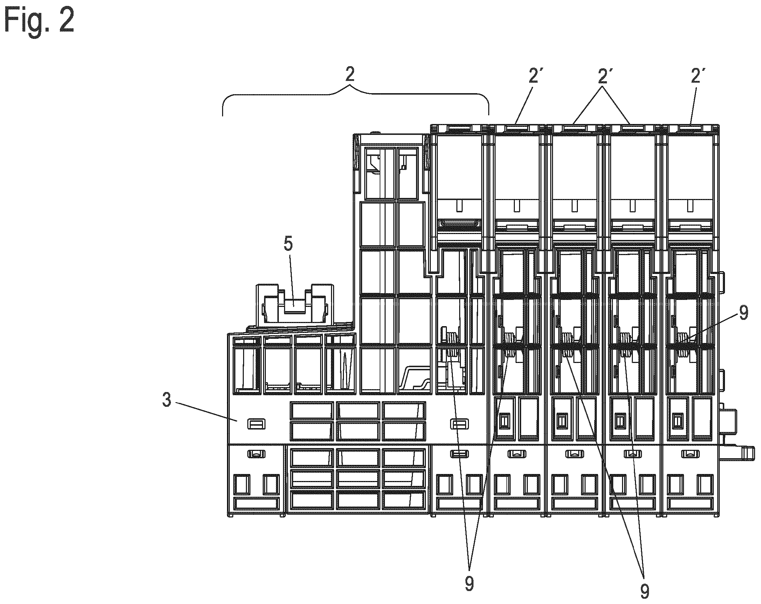

Figur 1 zeigt zunächst in einer räumlichen Darstellung eine Anordnung 1 aneinandergereihter kommunikationsfähiger Module 2, 2'. Die Module 2, 2' der Anordnung 1 bilden hier beispielhaft ein sogenanntes "Remote I/O"-System, also eine Ein- bzw. Ausgabestation für analoge und oder digitale Signale, die mit einem Steuerungssystem verbunden ist und entfernt von dieser positioniert sein kann. Figur 2 zeigt die Anordnung 1 gemäß Figur 1 in einer Seitenansicht.

Bei der gezeigten Anordnung 1 stellt das Modul 2 ein sogenanntes Kopfmodul (Kopfstation) dar und wird nachfolgend auch als Kopfmodul 2 bezeichnet. Die weiteren Module 2' sind Ein- und Ausgabemodule und werden der einfacheren Darstellung nachfolgend auch als I/O-Module 2' bezeichnet.

Alle Module 2, 2' weisen jeweils ein Gehäuse 3 auf, das hier in der Figur 1 im unteren Bereich mit einer Tragschienenaufnahme 4 zum Aufrasten auf eine Tragschiene zum Beispiel in einem Schaltschrank ausgestattet ist. Die in der Figur 1 unten dargestellte Seite ist bei Montage der Anordnung 1 vom Benutzer abgewandt, während die in der Figur 1 oben dargestellte Seite in der Regel eine Frontseite der Anordnung 1 darstellt und im Schaltschrank dem Benutzer zugewandt ist.

Das Kopfmodul 2 umfasst Anschlüsse 5, die zum Anschließen eines Feldbusses dienen, mit dem das Kopfmodul 2 mit einer hier nicht dargestellten Steuereinrichtung kommuniziert. Als Feldbusanschluss kann z.B. ein CAN-Bus oder auch ein Ethernet-basierter Feldbus, zum Beispiel ein EtherCAT-Bus eingesetzt werden.

Die Anschlüsse 5 sind fest in das Gehäuse 3 eingebaut. Daneben weist die Kopfstation 2 noch weitere Anschlüsse 6, z.B. zur Stromversorgung, auf, die austauschbar in Form von Anschlussblöcken ausgebildet sind, die in eine entsprechende Aussparung an der Oberseite des Gehäuses 3 eingesetzt werden können.

Die I/O-Module 2' werden ebenfalls auf die Tragschiene aufgesetzt und werden an das Kopfmodul 2 bzw. an ein benachbartes I/O-Modul 2' angerastet, wodurch die in der Figur 1 dargestellte Anordnung 1 modular entsteht. Die Anzahl von hier vier I/O-Modulen 2' ist rein beispielhaft. Die I/O-Modulen 2' weisen an ihrer im Einbauzustand im Schaltschrank vorderen Seite ebenfalls austauschbare Anschlüsse 6 auf. Diese Anschlüsse dienen einer Verbindung mit Sensoren und/oder Aktoren beispielsweise einer Industrieanlage oder einer Gebäudeautomation.

Beim Aneinanderreihen der Module 2, 2' wird durch hier nicht sichtbare Kontakte an den einander zugewandten Seitenflächen der Module 2, 2' ein Energieversorgungsbus und ein Datenbus gebildet, der das Kopfmodul 2 und die I/O-Module 2' untereinander im Hinblick auf eine Stromversorgung und einen Datenaustausch miteinander verbindet.

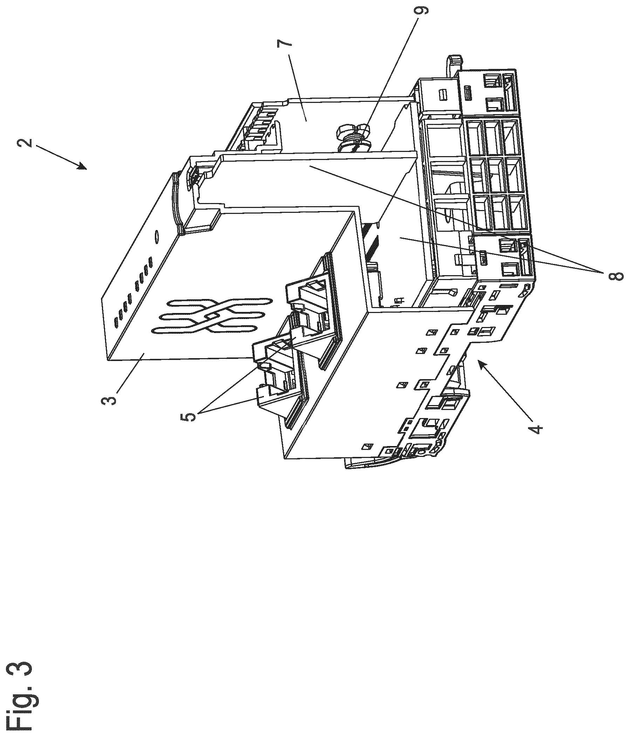

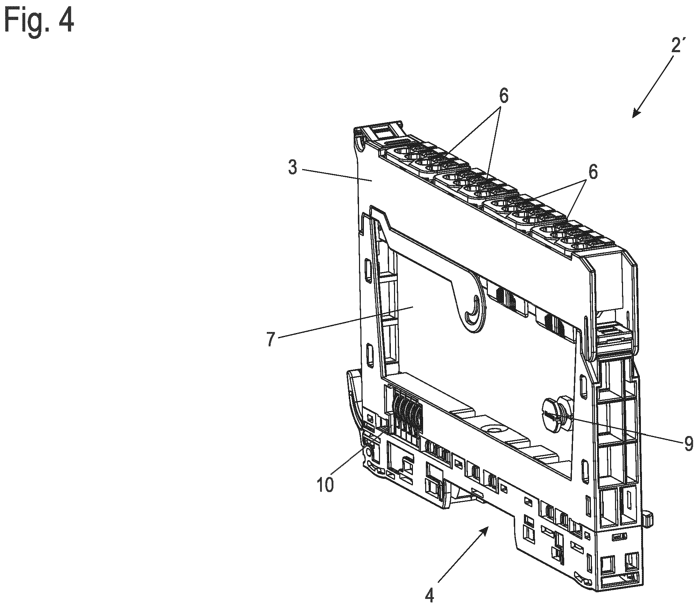

Der innere Aufbau des Kopfmoduls 2 ist auch nochmals in einer teilweise geschnittenen Zeichnung in Figur 3 wiedergegeben und der innere Aufbau eines der I/O-Module 2' in einer Darstellung in Figur 4, bei der ein Gehäuseseitenteil entfernt ist. In diesen Darstellungen ist zu erkennen, dass sowohl das Kopfmodul 2 als auch die I/O-Module 2' jeweils mindestens eine Leiterplatte 7 aufweisen, die innerhalb des Gehäuses 3 senkrecht zur Tragschiene ausgerichtet ist. Das Kopfmodul 2 weist weitere Leiterplatten 8 auf, die teilweise auch in anderer Orientierung als die Leiterplatte 7 im Gehäuse 3 angeordnet sind. Bei dem I/O-Modul 2' sind in der Darstellung der Figur 4 auch Datenbuskontakte 10 erkennbar.

An jeweils vergleichbarer Position auf der Leiterplatte 7 ist bei jedem der Module 2, 2' eine Spule 9 angeordnet. Beispielhaft ist die Spule 9 als Stabspule auf einem beidseitig offenen Kern ausgebildet. Der Kern kann beispielsweise ein Ferritkern sein. Wenn die Module 2, 2' zu der Anordnung 1 aneinandergereiht sind, liegen die Längsachsen aller Spulen 9 im Wesentlichen auf einer Achse, die parallel zur Tragschiene verläuft. Der einfachen Darstellung halber sind die Leiterplatten 7, 8 ohne weitere elektrische bzw. elektronische Bauelemente dargestellt.

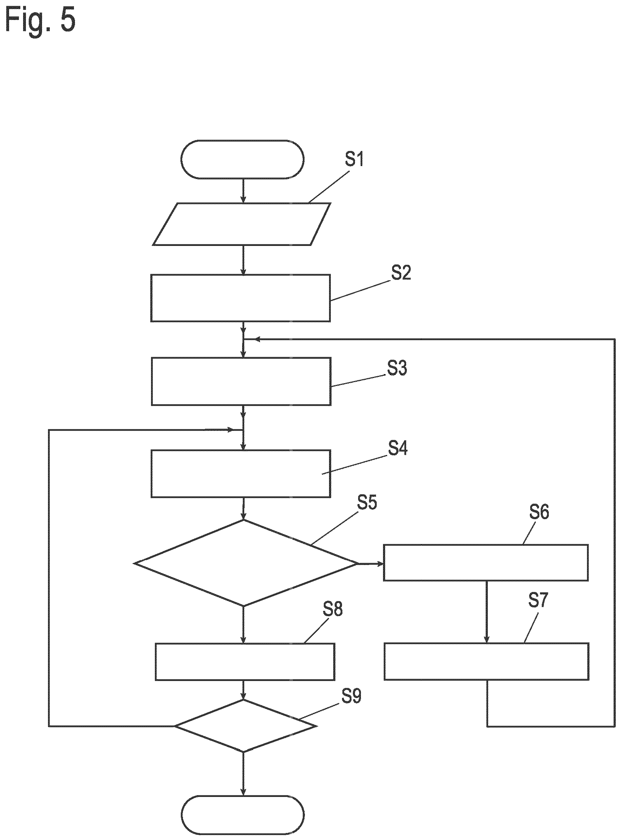

Die Spulen 9 dienen, wie nachfolgend anhand eines Flussdiagramms in Figur 5 erläutert wird, anmeldungsgemäß dazu, ein jeweils nächstes, benachbartes Modul 2' ausgehend von dem Kopfmodul 2 zu detektieren und dadurch eine Reihenfolge der Anordnung der Module 2, 2' mithilfe einer Erfassungseinheit zu ermitteln.

Das in der Figur 5 dargestellte Ausführungsbeispiel eines anmeldungsgemäßen Verfahrens zum Ermitteln der Reihenfolge der angereihten Module 2, 2' wird beispielhaft mit Bezug auf die Anordnung 1 der Figuren 1 und 2 erläutert. Es versteht sich aber, dass das Verfahren auch bei anderen Anordnungen von aneinandergereihten Modulen 2, 2' ausgeführt werden kann. Insbesondere ist es auch für die Durchführung des Verfahrens nicht erforderlich, dass die Module 2, 2' untereinander über einen drahtgebundenen Datenbus verbunden sind, wie das beim Beispiel der Figuren 1 und 2 der Fall ist. Das Verfahren kann auch mit Modulen durchgeführt werden, die unabhängig voneinander Teil eines drahtlosen Kommunikationsnetzwerk sind. Der in der folgenden Erläuterung benutzte Begriff "Kommunikationskanal" ist in diesem Sinne als nicht einschränkend zu verstehen und kann über einen Datenbus oder ein Kommunikationsnetzwerk gebildet sein.

Für das folgende Verfahren wird davon ausgegangen, dass die genannte Erfassungseinheit, die das beschriebene Verfahren koordiniert und die Reihenfolge der Module 2, 2' erfasst, in dem Kopfmodul 2 angeordnet ist. Auch dieses ist keine Notwendigkeit: das Verfahren könnte auch von einer Erfassungseinheit koordiniert werden, die außerhalb der Kopfstation 2 angeordnet ist, solange die Kopfstation 2 und die I/O- Module 2' mit dieser Erfassungseinheit kommunizieren können.

Ein erster Schritt S1 in dem Flussdiagramm der Figur 5 ist ein optionaler Schritt, in dem ein sich anschließender Erfassungsvorgang den I/O-Modulen 2' bzw. gegebenenfalls auch dem Kopfmodul 2 angekündigt wird. Nach dieser Ankündigung aktivieren die Module 2, 2' eine Detektionsschaltung für ein in der jeweiligen Spule 9 induziertes Signal. Wenn der Schritt S1 nicht vorgesehen ist, sind die entsprechenden Detektionsschaltungen dauerhaft aktiv.

In einem folgenden Schritt S2 wird eine Zählvariable n für eine Modulnummer auf einen Initialwert gesetzt, beispielsweise auf den Wert null: n=0.

In einem folgenden Schritt S3 wird eine Variable T für eine Pulslänge ebenfalls auf einen Initialwert, beispielhaft den Wert Tmin, gesetzt: T=Tmin.

In einem darauffolgenden Schritt S4 wird dann von einem ersten der Module 2, 2', dem die Modulnummer des Initialwerts zugeordnet wird, ein Spannungsimpuls der Pulslänge T auf die Spule 9 gegeben, der zur Ausgabe eines magnetischen Signal einer bestimmten Amplitude führt. Es wird beispielhaft davon ausgegangen, dass das Modul mit der initialen Nummer (n=0) das Kopfmodul 2 ist.

Wenn die Spule 9 mit einem i.W. rechteckförmigen Spannungspuls beaufschlagt wird, steigt ein Strom in der Spule 9 innerhalb der Pulslänge T in erster Näherung linear an, wobei die Magnetfeldstärke des aufgebauten Magnetfelds ebenfalls linear steigt. Je länger der Puls andauert, umso größer wird somit die Feldstärke des Magnetfelds, das die Spule 9 aufbaut.

In einem folgenden Schritt S5 wird ermittelt, ob eines der I/O-Module 2' den von der Spulen 9 des Kopfmoduls 2 ausgegebenen Magnetpuls detektiert hat. Zu diesem Zweck überwachen die I/O-Module 2' eine in ihrer Spule 9 induzierte Spannung. Falls die induzierte Spannung einen Schwellenwert übersteigt, sendet das entsprechende Modul 2' eine Nachricht über einen Kommunikationskanal an die Erfassungseinheit, dass ein Magnetfeld erkannt wurde. Der Kommunikationskanal ist in der Anordnung 1 der Figuren 1 und 2 der zwischen dem Kopfmodul 2 und den I/O-Modulen 2' aufgebaute Datenbus.

Wenn eine Antwort eines der I/O-Module 2' innerhalb einer vorgegebenen Zeitspanne, die beispielsweise im Bereich von einer bis mehreren Millisekunden liegt, empfangen wird, verzweigt das Verfahren zu einem nächsten Schritt S6. Falls keine Nachricht innerhalb der vorgegebenen Zeitspanne empfangen wird, wird das Verfahren in einem Schritt S8 fortgeführt.

In dem Schritt S6 werden mit der Nachricht des I/O-Moduls 2' mitgesendete Identifikationsdaten dieses Moduls 2', beispielsweise seine Busadresse, in der Erfassungseinheit in eine Liste eingetragen, in der sich nachfolgend die Reihenfolge der Module 2, 2' widerspiegelt.

Weiter kann vorgesehen sein, dass Konfigurationsdaten von der Erfassungseinheit an das I/O-Modul 2', das die Nachricht gesendet hat, geschickt werden, beispielsweise eine ihm zuzuordnende Modulnummer. Vorteilhaft wird als Modulnummer der Wert (n+1) zugeordnet.

In einem folgenden Schritt S7 wird die Zählvariable n dann um den Wert 1 inkrementiert und das Verfahren verzweigt zurück zum Schritt S3, in dem die Pulsbreite T wieder auf den Initialwert Tmin gesetzt wird.

Das Verfahren durchläuft dann erneut den Schritt S4, in dem ein Magnetpuls ausgegeben wird, allerdings wird jetzt der Magnetpuls nicht mehr von der Kopfstation 2, sondern von eben jenem I/O-Modul 2' ausgegeben, das zuvor das Magnetfeld detektiert hatte. Dieses kann auf Basis eines entsprechenden Befehls erfolgen, den die Erfassungseinheit an das I/O-Modul 2' über den Kommunikationskanal sendet.

Wiederum wird in dem erneut durchlaufenden folgenden Schritt S5 auf eine Antwort eines der noch nicht erkannten I/O-Module 2' gewartet. Ein bereits erkanntes I/O-Modul 2' und insbesondere auch das den Magnetimpuls aktuell abgebende I/O-Modul 2', hat seine Detektionsschaltung deaktiviert.

Wenn in dem Schritt S5 innerhalb der vorgegebenen Zeitspanne kein weiteres I/O-Modul 2' über den Kommunikationsbus mitteilt, dass es ein magnetisches Signal detektiert hat, wird das Verfahren in dem Schritt S8 fortgeführt, in dem die Variable T für die Pulsbreite um einen vorgegebenen Wert ΔT erhöht wird.

**In** einem nächsten Schritt S9 wird überprüft, ob eine vorgegebene maximale Pulslänge Tmax erreicht ist. Wenn die maximale Pulslänge Tmax erreicht ist, wird das Verfahren beendet. Wenn die maximale Pulslänge Tmax nicht erreicht ist, verzweigt das Verfahren zurück zu dem Schritt S4, in dem ein Magnetpuls vom gleichen I/O-Modul 2' wie zuvor erneut ausgegeben wird, diesmal allerdings mit der um den Wert ΔT verlängerten Pulslänge T und damit mit größerer Amplitude des Magnetfelds.

Die Schritte S4 bis S9 werden ggf. so lange wiederholt, bis entweder eines der bislang noch nicht erfassten I/O-Module 2' das magnetische Signal detektiert oder bis die maximale Pulslänge Tmax erreicht ist. Durch die schrittweise Erhöhung der Magnetfeldamplitude wird dabei die Reichweite des Magnetpulses (bei gegebener Detektionssensitivität) erhöht. Auf diese Weise wird erreicht, dass jeweils das am nächsten benachbarte I/O-Modul 2 als nächstes Modul 2, 2' detektiert wird. Bei dem Verfahren werden so sukzessive ausgehend von einer Seite der Anordnung 1 - hier konkret ausgehend von dem Kopfmodul 2 - alle angereihten I/O-Module 2' in der Reihenfolge ihrer Anordnung erfasst.

### Bezugszeichen

- 1: Anordnung
- 2: Modul (Kopfmodul)
- 2': weiteres Modul (I/O-Modul)
- 3: Gehäuse
- 4: Tragschienenaufnahme
- 5: Anschluss (fest)
- 6: Anschluss (austauschbar)
- 7: Leiterplatte
- 8: weitere Leiterplatte
- 9: Spule
- 10: Datenbuskontakte

## Patentansprüche

1. Verfahren zum Ermitteln einer Reihenfolge, in der mindestens drei aneinandergereihte kommunikationsfähige Module (2, 2') angeordnet sind, aufweisend die folgenden Schritte:
- Ausgeben eines magnetischen Signals von einem ersten der Module (2, 2') mit einer vorgegebenen Intensität;
- Steigern der Intensität des Signals, bis das Signal von einem unmittelbar an das sendende Modul (2, 2') angrenzenden der Module (2, 2') detektiert wird, von einem nicht unmittelbar angrenzenden der Module (2, 2') jedoch nicht detektiert wird;
- Ausgeben von Identifikationsdaten durch dasjenige der Module (2, 2'), das das magnetische Signal detektiert hat, über einen Kommunikationskanal an eine Erfassungseinheit; und
- Erfassen eine Reihenfolge der Module (2, 2') anhand der Identifikationsdaten.

2. Verfahren nach Anspruch 1, bei dem nach dem Ausgeben der Identifikationsdaten durch dasjenige der Module (2, 2'), das das magnetische Signal detektiert hat, die Intensität des von dem ersten der Module (2, 2') gesendeten magnetischen Signal weiter gesteigert wird, bis das magnetische Signal von einem weiteren der Module (2, 2') detektiert wird, das dann Identifikationsdaten über den Kommunikationskanal an die Erfassungseinheit übermittelt.

3. Verfahren nach Anspruch 1, bei dem nach dem Ausgeben der Identifikationsdaten dasjenige der Module (2, 2'), das das magnetische Signal detektiert hat, das sich ausgehend von der vorgegebenen Intensität steigernde magnetische Signal ausgibt, bis das magnetische Signal von einem weiteren der Module (2, 2') detektiert wird, das dann Identifikationsdaten über den Kommunikationskanal an die Erfassungseinheit übermittelt.

4. Verfahren nach Anspruch 2 oder 3, bei dem die Schritte des Ausgebens des magnetischen Signals, des Detektierens des magnetischen Signals durch ein weiteres der Module (2, 2') und des Übermittelns der Identifikationsdaten wiederholt durchgeführt werden, bis alle Module (2, 2') der Anordnung (1) erfasst sind.

5. Verfahren nach einem der Ansprüche 1 bis 4, bei die Erfassungseinheit nach dem Empfangen der Identifikationsdaten Konfigurationsdaten an das Modul (2, 2'), das die Identifikationsdaten gesendet hat, übermittelt.

6. Verfahren nach einem der Ansprüche 1 bis 5, bei dem das magnetische Signal durch jeweils eine Spule (9) erzeugt und/oder detektiert wird, die in jedem der Module (2, 2') angeordnet ist.

7. Verfahren nach Anspruch 6, bei dem das magnetische Signal ein Magnetpuls ist, der durch Beaufschlagen der Spule (9) mit einem rechteckförmigen Spannungssignal einer vorgebbaren Pulsbreite (T) erzeugt wird.

8. Verfahren nach Anspruch 7, bei dem die Intensität des magnetischen Signals dadurch gesteigert wird, dass die Pulsbreite (T) erhöht wird.

9. Anordnung (1) aus mindestens drei aneinanderreihbaren kommunikationsfähigen Modulen (2, 2'), die jeweils eine Spule (9) zum Ausgeben und/oder Empfangen eines magnetischen Signals aufweisen, sowie einer Erfassungseinheit, wobei die Anordnung (1) zur Durchführung eines Verfahrens nach einem der Ansprüche 1 bis 8 ausgebildet ist.

10. Anordnung (1) nach Anspruch 9, bei der alle Spulen (9) entlang einer gemeinsamen Achse angeordnet sind.

11. Anordnung (1) nach Anspruch 9 oder 10, bei der die Spulen (9) Stabspulen sind.

12. Anordnung (1) nach einem der Ansprüche 9 bis 11, bei der die Spulen (9) einen Ferritkern aufweisen.

## Claims

1. A method of ascertaining a sequence in which at least three strungtogether communication-capable modules (2, 2') are arranged, having the following steps:
- outputting a magnetic signal from a first of the modules (2, 2') with a predefined intensity;
- increasing the intensity of the signal, until the signal is detected by a module of the modules (2, 2') which is immediately adjacent to the transmitting module (2, 2'), but which is not detected by a module of the modules (2, 2') which is not immediately adjacent to the transmitting module (2, 2');
- outputting identification data through that one of the modules (2, 2') which has detected the magnetic signal, via a communication channel to a determining unit; and
- determining a sequence of the modules (2, 2') by means of the identification data.

2. The method according to claim 1, in which, after the identification data has been output by that one of the modules (2, 2') which has detected the magnetic signal, the intensity of the magnetic signal transmitted by the first of the modules (2, 2') is increased further until the magnetic signal is detected by another of the modules (2, 2'), which then forwards the identification data to the determining unit via the communication channel.

3. The method according to claim 1, in which, after the identification data has been output, that one of the modules (2, 2') which has detected the magnetic signal outputs a magnetic signal which increases starting from the predefined intensity until the magnetic signal is detected by another of the modules (2, 2'), which then forwards identification data to the determining unit via the communication channel.

4. The method according to claim 2 or 3, in which the steps of outputting the magnetic signal, detecting the magnetic signal by another of the modules (2, 2') and forwarding the identification data are performed repeatedly until all modules (2, 2') of the arrangement (1) are determined.

5. The method according to any one of claims 1 to 4, in which after receiving the identification data the determining unit forwards configuration data to the module (2, 2') which transmitted the identification data.

6. The method according to any one of claims 1 to 5, in which the magnetic signal is generated and/or detected by one coil (9) respectively which is arranged in each of the modules (2, 2').

7. The method according to claim 6, in which the magnetic signal is a magnetic pulse generated by supplying to the coil (9) a rectangular voltage signal of a predefinable pulse width (T).

8. The method according to claim 7, in which the intensity of the magnetic signal is raised in that the pulse width (T) is increased.

9. An arrangement (1) of at least three communication-capable modules (2, 2') able to be strung together, which each have a coil (9) for outputting and/or receiving a magnetic signal, and of a determining unit, wherein the arrangement (1) is constructed to perform a method according to any one of claims 1 to 8.

10. The arrangement (1) according to claim 9, in which all coils (9) are arranged along a common axis.

11. The arrangement (1) according to claim 9 or 10, in which the coils (9) are poloidal coils.

12. The arrangement (1) according to any one of claims 9 to 11, in which the coils (9) have a ferrite core.

## Revendications

1. Procédé pour déterminer un ordre dans lequel sont disposés au moins trois modules (2, 2') capables de communication alignés les uns avec les autres, comprenant les étapes suivantes :
- émission d'un signal magnétique par un premier des modules (2, 2') à une intensité prédéterminée ;
- augmentation de l'intensité du signal jusqu'à ce que celui-ci soit détecté par un des modules (2, 2') immédiatement contigu du module (2, 2') émetteur mais pas par un des modules (2, 2') qui n'est pas immédiatement contigu ;
- transmission de données d'identification à une unité d'acquisition par celui des modules (2, 2') qui a détecté le signal magnétique sur un canal de communication et
- acquisition d'un ordre des modules (2, 2') à l'aide des données d'identification.

2. Procédé selon la revendication 1 dans lequel, après l'émission des données d'identification par celui des modules (2, 2') qui a détecté le signal magnétique, l'intensité du signal magnétique émis par le premier des modules (2, 2') est encore augmentée jusqu'à ce que le signal magnétique soit détecté par un autre des modules (2, 2'), qui transmet ensuite des données d'identification à l'unité d'acquisition sur le canal de communication.

3. Procédé selon la revendication 1 dans lequel, après l'émission des données d'identification, celui des modules (2, 2') ayant détecté le signal magnétique émet le signal magnétique augmenté à partir de l'intensité prédéterminée jusqu'à ce que celui-ci soit détecté par un autre des modules (2, 2'), qui transmet ensuite des données d'identification à l'unité d'acquisition sur le canal de communication.

4. Procédé selon la revendication 2 ou 3, dans lequel les étapes d'émission du signal magnétique, de détection du signal magnétique par un autre des modules (2, 2') et de transmission des données d'identification sont exécutées de façon répétée jusqu'à ce que tous les modules (2, 2') de la disposition (1) soient acquis.

5. Procédé selon l'une des revendications 1 à 4 dans lequel, après avoir reçu les données d'identification, l'unité d'acquisition transmet des données de configuration au module (2, 2') qui a émis les données d'identification.

6. Procédé selon l'une des revendications 1 à 5, dans lequel le signal magnétique est généré et/ou détecté respectivement par une bobine (9) qui est disposée dans chacun des modules (2, 2').

7. Procédé selon la revendication 6, dans lequel le signal magnétique est une impulsion magnétique qui est générée par l'application à la bobine (9) d'un signal de tension rectangulaire dont la largeur d'impulsions (T) peut être prédéterminée.

8. Procédé selon la revendication 7, dans lequel l'intensité du signal magnétique est augmentée par le fait que la largeur d'impulsion (T) est augmentée.

9. Disposition (1) composée d'au moins trois modules (2, 2') capables de communication alignés les uns avec les autres, qui comportent chacun une bobine (9) pour émettre et/ou recevoir un signal magnétique ainsi qu'une unité d'acquisition, laquelle disposition (1) est conçue en vue de l'exécution d'un procédé selon l'une des revendications 1 à 8.

10. Disposition (1) selon la revendication 9, dans laquelle toutes les bobines (9) sont disposées le long d'un axe commun.

11. Disposition (1) selon la revendication 9 ou 10, dans laquelle les bobines (9) sont des enroulements à barres.

12. Disposition (1) selon l'une des revendications 9 à 11, dans laquelle les bobines (9) comportent un noyau de ferrite.
